Europäisches Patentamt

(19) European Patent Office     (11) Publication number: **0 170 022**

Office européen des brevets     **B1**

(12)                   EUROPEAN PATENT SPECIFICATION

(45) Date of publication of patent specification: **11.10.89**     (51) Int. Cl.⁴: **H 01 L 21/60,** H 01 L 23/48,
                                                                    H 01 L 23/36

(21) Application number: **85107440.1**

(22) Date of filing: **19.06.85**

(54) Semiconductor power device package for surface mounting.

(30) Priority: **31.07.84 US 636189**

(43) Date of publication of application:
**05.02.86 Bulletin 86/06**

(45) Publication of the grant of the patent:
**11.10.89 Bulletin 89/41**

(84) Designated Contracting States:
**DE FR GB**

(56) References cited:
**US-A-4 132 856**

**IBM TECHNICAL DISCLOSURE BULLETIN, vol.
22, no. 2, July 1979, page 522, New York, US;
S.K. WADHWA: "Low-cost circuit packaging"**

**IBM TECHNICAL DISCLOSURE BULLETIN, vol.
26, no. 10B, March 1984, pages 5764,5765, New
York, US; K.A. VANDERLEE: "Substrate for
high power packaging"**

(73) Proprietor: **International Business Machines
Corporation
Old Orchard Road
Armonk, N.Y. 10504 (US)**

(72) Inventor: **Schrottke, Gustav
11101 Spicewood Parkway
Austin Texas 78750 (US)**
Inventor: **Talkington, Alan Lee
1006 Deet Run
Round Rock Texas, 78664 (US)**

(74) Representative: **Colas, Alain
Compagnie IBM France Département de
Propriété Intellectuelle
F-06610 La Gaude (FR)**

(56) References cited:
**ELECTRONIC DESIGN, vol. 28, no. 18, 1st
September 1980, page 42, Waseca MN,
Denville New Jersey, US; R. SHINN: "Overmold
packages firm up TO-220 advantages"**

Courier Press, Leamington Spa, England.

## Description

This invention relates to semiconductor packaging in general, and more particularly to a miniature package for semiconductor power devices suitable for fully automated manufacturing and testing before mounting in the next higher level of packaging.

Representative of the closest known prior art is U.S. Patent 4,038,744 to Cheype et al, filed April 27, 1976 and entitled "Methods of Manufacturing Carrier Supports for Integrated Chips and Mounting of Integrated Circuit Chips to a Substrate"; U.S. Patent 4,283,839 to Gursky, filed July 7, 1980 (division of U.S. Patent 4,234,666 filed July 26, 1978), and entitled "Method of Bonding Semiconductor Devices to Carrier Tapes" and U.S. Patent 4,356,374 to Noyori et al, filed July 10, 1980, (division of U.S. Patent 4,246,595 filed February 28, 1979), and entitled "Electronics Circuit Device and Method of Making Same". Additionally, U.S. Patent 3,855,693 to Umbaugh, filed April 18, 1973, and entitled "Method for Assembling Microelectronic Apparatus" was considered relative to this invention and found to be of less pertinence than the previously cited art.

In early power semiconductor packages, silicon or germanium power devices were mounted either directly to a header or to a thermal expansion matcher which separated the semiconductor power device from the outside of the case of the package. When the semiconductor device was mounted directly to the header, it was known that the thermal expansion rates were different between the semiconductor device and the header. Thus, thermal expansion matching devices were used in an attempt to provide an interface between the different expansion rates of the semiconductor devices and the headers, although, because of their expense and added complexity to the manufacturing process, the thermal expansion matching devices were generally used only with larger, or relatively high power, semiconductor packages. Representative of a smaller package of this variety was the industry standard TO-5 package, and representative of a larger of this variety of packages was the industry standard TO-3 package.

In packages such as the TO-5 and TO-3 for transistors, the collector of the transistor was typically bonded directly to the metal case or to the thermal expansion matcher separating it from the metal case by means of a solder or eutectic bond. The emitter and base leads were typically wire bonded to conductive pins or leads mounted in the package. These packages were then hermetically sealed and the sealing compound typically provided support for the emitter and base leads. Although these packages were relatively expensive, the package cost was a relatively minor fraction of the cost of the semiconductor device itself.

As semiconductor device manufacturing costs have dropped significantly, especially in the past two decades, the cost of the semiconductor device itself (now silicon in almost all instances) has become a much lower portion of the total cost of a TO-3 packaged semiconductor. Accordingly, for lower cost packages, industry has moved to plastic encapsulated packages. Plastic encapsulated packages have dramatically lowered the prices of semiconductor devices of all types, including power semiconductor packages; however, reliability has been a problem in the relatively higher power semiconductor device plastic packages. Plastic encapsulated packages have been fairly reliable for low power semiconductor devices because the absolute temperature rise during operation is not high.

To provide enhanced thermal performance in power devices packaged with plastic encapsulation techniques, a metal heat spreader is usually employed. The semiconductor device is mounted to the heat spreader and plastic encapsulation encloses the portion of the heat spreader on which the semiconductor device is mounted but leaves a portion of the heat spreader exposed for attachment to a heat sink. As in the metal semiconductor packages (and using a transistor for this example), wire bonding is typically used between the semiconductor device and the emitter and base leads before this portion of the package is totally encapsulated with a plastic resin. Thus, the wire bonded leads become embedded in the plastic upon encapsulation. However, the plastic encapsulation material, the heat spreader, and the silicon expand and contract at different rates during the temperature cycles of normal operation of the device. This causes stresses on the wire bonded leads, and frequently, ultimate failure of these leads or bonds at the ends thereof.

Accordingly, while these plastic encapsulated devices have greatly lowered the cost of completed packaged, power semiconductors, reliability problems are, nevertheless, present. Additionally, the plastic encapsulated packaging techniques described immediately above are not the most cost effective, high volume manufacturing techniques because these approaches do not provide for testing the semiconductor device after mounting to the heat spreader until the plastic encapsulation process is complete. Device failures often occur due to the temperature rise which is encountered during mounting to the heat spreader. Additionally, the completed power package is not automatically mountable to a printed circuit board, or other next higher level of packaging.

Tape automatic bonding (TAB) techniques are gaining wide acceptance as a semiconductor packaging technique because of the ability to automate this production process to provide high volume packaging. Three examples of this technique are shown in the aforementioned U.S. Patents 4,038,744, 4,283,839, and 4,356,374. U.S. Patent 4,038,744 shows a technique for mounting a semiconductor chip on a polyimide film on which wiring patterns are formed before mounting by metallizing the film and etching away selected areas to leave the remaining areas in the desired wiring pattern. U.S. Patent 4,283,839 shows a TAB mounting technique in which the tape is simply the conductor, itself, with no substrate such as polyimide. U.S. Patent 4,356,374 refers to a TAB technique in which beam leads are mounted between a semiconductor device and a substrate, which beam leads themselves are formed on a polyimide tape. While these techniques lend themselves to high volume manufacture, they have not, in the prior art, lent themselves to the packaging of power devices because the prior art heat sinking techniques have not been compatible with the highly automated TAB packaging technology.

In summary, therefore, it would be highly desirable to provide an inexpensive package for high power semiconductor devices, which package is capable of highly automated, high volume production, and testing during manufacture, to provide a very reliable packaged semiconductor power device.

Accordingly, a miniature package having the features such as claimed in claim 1 is provided for power semiconductor devices which package is adaptable to tape automatic bonding (TAB) techniques. Such a device is provided by a method in which an elongated strip or tape of a film such as polyimide forms the substrate for a plurality of packages; a repeating metallization pattern is formed on the polyimide film; a thermal expansion matching material is repetitively mounted to a particular area on each of the repeating metallized patterns; at least one semiconductor power device is then mounted to each thermal expansion matcher and, in the preferred embodiment, beam leads connect areas of the semiconductor device to other areas of the metallization on the repeating pattern. The beam leads can also be attached by a second TAB technique.

The multiple semiconductor devices now mounted and connected to the tape can be conveyed, automatically, through a testing station to eliminate the remainder of the manufacturing process relative to those devices which fail the test. The devices or multiple device assemblies on the tape which pass the tests are then passivated using a small amount of low expansion plastic material which fully encloses only the semiconductor device and thermal expansion matcher. The tape containing this plurality of packages is retested and the individual packages are excised from the tape. Miniature power semiconductor packages containing the fully tested power devices are now ready for mounting on the next higher level packaging substrate.

The foregoing and other objects, features, extensions, and advantages of the invention will be apparent from the following more particular description of preferred embodiments of the invention, as illustrated in the accompanying drawings.

Fig. 1 is a perspective view of a semiconductor power device package of this invention.

Fig. 2 is a top view of the substrate film of the package of this invention before metallization.

Fig. 3 is a top view of the substrate film of the package of this invention after metallization.

Fig. 4 is an enlarged side elevation view of the power semiconductor package of this invention structurally, electrically, and thermally attached to a typical next higher level of packaging.

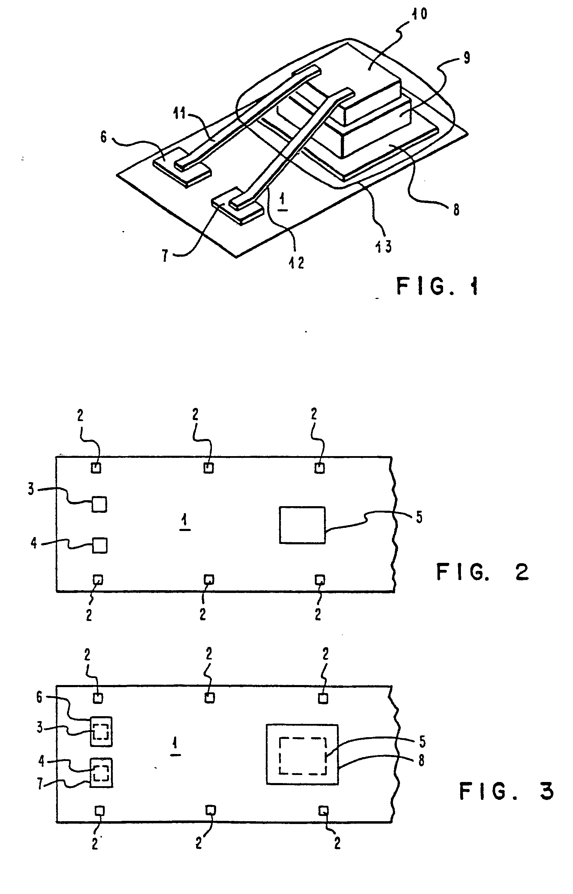

Referring now to Fig. 1, a perspective view of the miniature semiconductor power device package of this invention is shown. In describing the structure and the automated manufacturing technique for the package shown in Fig. 1, it will be helpful to refer to Figs. 2 and 3 for a description of the underlying structure and manufacturing process.

Referring to Fig. 2, an elongated, insulated substrate film 1 is shown which may typically, for example, be a polyimide tape. Consistent with well known tape automatic bonding (TAB) manufacturing techniques, the film 1 includes a plurality of sprocket holes 2 suitable for automated feeding by TAB manufacturing equipment. Additionally, film 1 is manufactured with a plurality of sets of excised holes 3, 4, and 5. Accordingly, while only one set of holes 3, 4, and 5 are shown in Fig. 2, it will be understood by those skilled in the art that the elongated tape comprising film 1 in Fig. 2 has a plurality of excised holes 3, 4, and 5 in a repeating pattern along the tape identical to the example of this pattern shown in Fig. 2.

Referring now to Fig. 3, a portion of film 1 is shown on which metallized patterns 6, 7 and 8 overlie the excised holes 3, 4, and 5, respectively. The metallized patterns may be formed of copper, for example, and may be formed on the polyimide film 1 by well known manufacturing techniques such as plating and etching. The bonding areas of the metallized patterns 6, 7 and 8 may advantageously have gold flashing deposited on at least portions of the exposed surfaces thereof to facilitate (on the semiconductor device side of the tape) the soldering or eutectic bonding of the thermal expansion matcher and beam leads to the metallized patterns and (on the opposite side of the tape) to facilitate soldering (or other bonding techniques) to the next higher packaging level.

Referring back to Fig. 1, a portion of the film 1 is shown which includes the metallized patterns 6, 7, and 8. To metallized pattern 8 is attached a thermal expansion matching material. The thermal expansion matching material may be, for example, a clad of Copper-Molybdenum-Copper or Copper-Invar*-Copper. Invar* is a steel alloy which contains approximately 36% nickel.

The thermal expansion matcher is attached to the metallized pattern 8 by soldering and is also solderable on the opposite side thereof. Semi

*Invar is a trademark of Texas Instruments Incorporated.

conductor power device 10, typically a silicon device, is solder mounted to the surface of thermal expansion matcher 9 opposite the surface of matcher 9 mounted to the metallized pattern 8.

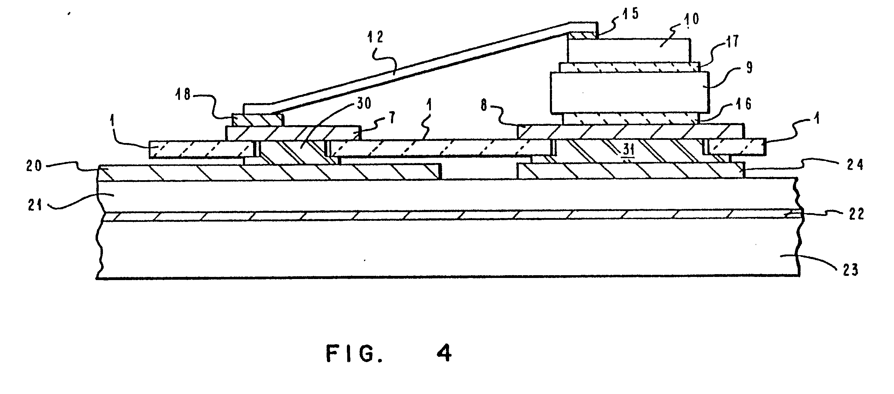

Accordingly, the thermal expansion matcher 9 matches the thermal expansion of the silicon semiconductor power device 10 on one side and a substantially different thermal expansion rate of a heat sink material, such as aluminum, on the other side of the metallized pattern 8, as will be fully understood with reference to Fig. 4, below. It will be understood to those skilled in the art that the dimensions of the clad thermal expansion matcher are determined by the expansion rates of the silicon power semiconductor device and the heat sinking material (such as aluminum) in the next higher level of packaging. The thermal expansion matcher must be thermally conductive to conduct heat from the silicon power device to the heat sinking material and must also be electrically conductive to carry the high current of the semiconductor power device.

In Fig. 1, a pair of beam leads 11 and 12 are shown which electrically connect regions of the semiconductor power device 10 to the metallized patterns 6 and 7, respectively. For example, beam leads 11 and 12 in a transistor configuration may typically be base and emitter leads. In high current power devices, it will be understood that the emitter and base leads may be of substantially different sizes with a substantially larger beam lead being provided for the emitter than for the base of the transistor.

Those skilled in the art will understand that the construction described above for the miniature power semiconductor device package readily lends itself to complete automation. Upon manufacture of an elongated film with repeating metallized patterns as described in Figs. 2 and 3, attachment of the thermal expansion matcher 9, and semiconductive power device 10 can be accomplished with TAB techniques. Additionally, the metallization of the beam leads 11 and 12 can be formed on another tape substrate and these beam leads may also be mounted in this package utilizing a TAB technique.

After attachment of the thermal expansion matcher 9, power semiconductor device 10, and beam leads 11 and 12 to the metallized areas 8, 6, and 7, respectively, the film 1 including the partially completed package may be indexed to an automatic testing station whereupon suitable test probes of a testing apparatus (not shown) are brought into electrical contact with a portion (for example, the underside) of the metallized patterns 6, 7, and 8 to test the characteristics of the partially packaged semiconductor device 10. Through suitable means well known in the TAB art, those partially completed packages which fail this test are "flagged" to have the remainder of the manufacturing process omitted. Those partially completed packages passing the test are then indexed to a station (not shown) at which a relatively small amount of low expansion plastic material is deposited to enclose at least the semiconductor power device. In some configurations, this plastic passivation might totally enclose only the semiconductor power device and not all of the thermal expansion matcher. The plastic passivation material, such as a polymeric encapsulant, is indicated by the reference numeral 13 in Fig. 1 and, for the purposes of illustration only in Fig. 1, is shown as a transparent material, although those skilled in the art will understand that the passivation material 13 will most likely not be transparent. The polymeric passivation material may be a high purity epoxy with a silica filler.

After the passivation material is deposited, the film 1 on which the almost completed package is affixed is again indexed to a testing station (not shown) for a final test of the almost completed miniature semiconductor power device package. Those packages passing this test are then excised from the elongated tape 1 and appear as the package shown in Fig. 1 without the sprocket holes 2 shown in Figs. 2 and 3. Accordingly, the miniature power semiconductor package shown in Fig. 1 has been fully tested and is ready for installation into the next higher level of packaging.

Referring now to Fig. 4, an enlarged or magnified side elevation view of the miniature power semiconductor device package of this invention is shown mounted to a next higher packaging level. For ease of understanding, the reference numerals used in Fig. 1 are repeated in Fig. 4. Additionally, the passivation material 13 has been omitted from this figure, although it would be included in actual practice. Since this is an enlarged view, the layers of solder or other bonding material are also shown. Accordingly, a layer of solder 16 bonds the thermal expansion matcher 9 to the metallized portion 8, and a layer of solder 17 is used to bond the semiconductor power device 10 to the thermal expansion matcher 9. Similarly, a layer of solder 15 is used to attach one end of the beam lead 12 to the semiconductor device 10 and another layer of solder 18 is used to attach an opposite end of beam lead 12 to the metallized portion 7.

Reference numerals 20—24 denote the next higher packaging level on which the miniature power semiconductor device package of this invention is mounted. Metallized circuit wiring patterns 20 and 24 are affixed by plating or other deposition techniques to a relatively thin insulating film 21. Wiring patterns 20 and 24 may be, for example, copper and film 21 may be, for example, polyimide. A layer of suitable adhesive 22 is used to attach film 21 to a suitable heat sinking material 23 such as aluminum. The miniature semiconductor power device package of this invention, accordingly, is mounted to wiring patterns 20 and 24, etc. by solder layers 30 and 31. It will, therefore, be clearly understood that the thermal expansion matcher 9 matches the uneven rates of expansion of the aluminum heat sink 23 and the silicon semiconductor power device 10 to prevent failure of the bonding media between the aluminum heat sinking material 23 and the silicon semiconductor power device 10.

It will be understood by those skilled in the art that while a single power transistor package has been used for the purposes of describing this invention, the package in Fig. 1 might also be configured to accommodate a pair of power diodes for a power supply in which, for example, the cathodes of each diode might be soldered to the thermal expansion matcher 9 and the anodes of the diodes might be separately connected to metallized portions 6 and 7 by use beams leads 11 and 12 (of equal size in this application). Other component or semiconductor device combinations, of course, are also possible with this packaging technology.

## Claims

1. A semiconductor power device package, characterized in that it comprises:

a strip of film dielectric material (1) having at least two separated, metallized areas (6, 7, 8) on a surface thereof;

an electrically and thermally conductive thermal expansion matcher (9) mounted to a first (8) of said metallized areas;

a power semiconductor device (10) mounted to the surface of said thermal expansion matcher (9) opposite the surface of matcher (9) mounted to the metallized area (8);

beams leads (11, 12) electrically connecting portions of said semiconductor device to the other metallized areas.

said thermal expansion matcher (9) matching the thermal expansion rates of the semiconductor power device material and the heat sink material of the package.

2. The semiconductor power device package of Claim 1, further comprising a hole (3, 4, 5) in said strip of film dielectric material underlying each of said metallized areas.

3. The semiconductor power device package of Claim 1 or 2, wherein said metallized areas comprise a substantially thin copper layer.

4. The semiconductor power device package according to any one of Claims 1 to 3, wherein said film comprises polyimide.

5. The semiconductor power device package according to any one of Claims 1 to 4, wherein exposed surfaces of said metallized areas are at least partially covered with gold flashing.

6. The semiconductor power device package according to any one of Claims 1 to 5, wherein said thermal expansion matching material comprises a sandwich of Copper-Molybdenum--Copper.

7. The semiconductor power device package according to any one of Claims 1 to 5, wherein said thermal expansion matching material comprises a core of a steel alloy containing approximately 36% nickel, said core being clad with copper.

8. The semiconductor power device package according to any one of Claims 1 to 7 further comprising a substantially low expansion plastic passivation material (13) deposited to substantially enclose at least said power semiconductor device.

9. The semiconductor power device package of Claim 8, wherein said plastic passivation material comprises polymeric encapsulants.

10. The semiconductor power device package of Claim 9, wherein said polymeric encapsulant comprises a substantially high purity epoxy with a silica filler.

11. A semiconductor power device package, characterized in that it comprises:

a first strip of film dielectric material (1) having at least two separated, metallized areas (6, 7, 8) on a first surface thereof, said dielectric material including a hole (3, 4, 5) underlying each of said metallized areas;

a thermal expansion matcher (9) mounted to a first (8) of said metallized areas;

a beam lead (12) connecting a portion of said semiconductor device to a second (7) of said metallized areas;

a second film dielectric material (21) having at least two metallized areas (20, 24) of a first surface thereof;

a heat sink material (23) attached to a second surface of said second dielectric material; and said metallized areas of said first strip being electrically, mechanically and thermally connected to said metallized areas of said second film dielectric material through said hole underlying each of said metallized areas of said first strip.

12. The power semiconductor device package of Claim 11 wherein said second film dielectric material comprises polyimide.

13. The power semiconductor device package of Claim 12 wherein said heat sink comprises aluminum.

## Patentansprüche

1. Starkstrom-Halbleitervorrichtungspackung, dadurch gekennzeichnet, dass sie aufweist:

einem Streifen aus filmförmigem dielektrischem Werkstoff (1) mit zumindest zwei getrennten metallisierten Flächen (6, 7, 8) auf einer Oberfläche davon;

einen in elektrischer und thermischer Hinsicht leitenden Ausgleicher (9) für die Wärmeausdehnung, der auf einer ersten (8) der genannten Oberflächen angeordnet ist;

eine Leistungs-Halbleitervorrichtung (10), auf der Oberfläche des genannten Wärmeausgleichers (9) angeordnet, die der metallisierten Fläche (8) gerade gegenüberliegt;

Flachanschlüsse (11, 12), die Teilstücke der genannten Halbleitervorrichtung elektrisch mit den anderen metallisierten Flächen verbinden, wobei der genannte Wärmeausdehnungsausgleicher (9) die Wärmeausdehnungsraten des Werkstoffs für die Starkstrom-Halbleitervorrichtung dem Wärmeabgabewerkstoff der Packung anpasst.

## EP 0 170 022 B1

2. Starkstrom-Halbleitervorrichtungspackung nach Anspruch 1, die weiter ein Loch (3, 4, 5) im genannten Streifen aus filmförmigen dielektrischem Werkstoff aufweist, der unter jeder der genannten metallisierten Fläche liegt.

3. Starkstrom-Halbleitervorrichtungspackung nach Anspruch 1 oder 2, bei der die genannten metallisierten Flächen eine im wesentlichen dünne Kupferschicht aufweisen.

4. Starkstrom-Halbleitervorrichtungspackung nach allen der Ansprüche 1 bis 3, bei der der genannte Film Polyimid aufweist.

5. Starkstrom-Halbleitervorrichtungspackung nach allen der Ansprüche 1 bis 4, bei der die freiliegenden Oberflächen der genannten metallisierten Flächen zumindest teilweise mit einer Goldplattierung überdeckt sind.

6. Starktstrom-Halbleitervorrichtungspackung nach allen der Ansprüche 1 bis 5, bei der der Werkstoff zum Ausgleich der Wärmeausdehnung eine Kupfer-Molybdän-Kupfer-Verbundstruktur aufweist.

7. Starkstrom-Halbleitervorrichtungspackung nach allen der Ansprüche 1 bis 5, bei der der genannte Werkstoff zum Ausgleich der Wärmeausdehnung einen Kern aus Edelstahl mit ca. 36% Nickel aufweist und dieser Kern mit Kupfer ausgekleidet ist.

8. Starkstrom-Halbleitervorrichtungspackung nach allen der Ansprüche 1 bis 7, die weiter einen Passivierkunststoff (13) mit einer recht geringen Wärmeausdehnung aufweist, der zumindest die genannte Starkstrom-Halbleitervorrichtung umschliesst.

9. Starkstrom-Halbleitervorrichtungspackung nach Anspruch 8, bei der der genannte Passivierkunststoff polymere Vergiessmaterialien enthält.

10. Starkstrom-Halbleitervorrichtungspackung nach Anspruch 9, bei der das genannte polymere Vergiessmaterial ein im wesentlichen hochreines Epoxidharz mit Siliziumoxid als Füllermaterial aufweist.

11. Starkstrom-Halbletiervorrichtungspackung, dadurch gekennzeichnet, dass sie aufweist:
einen ersten Streifen aus filmförmigen dielektrischem Werkstoff (1) mit zumindest zwei getrennten metallisierten Flächen (6, 7, 8) auf einer Oberfläche davon, wobei der genannte dielektrische Werkstoff ein Loch (3, 4, 5) unter jeder der genannten metallisierten Flächen aufweist;
einen Ausgleicher (9) für die Wärmeausdehnung, auf einer ersten (8) der genannten metallisierten Oberflächen angeordnet;
einen Flachanschluss (12), der ein Teilstück der genannten Halbleitervorrichtung mit einer zweiten (7) der genannten metallisierten Flächen verbindet;
einen zweiten Streifen aus filmförmigem dielektrischem Werkstoff (21) mit zumindest zwei getrennten metallisierten Flächen (20, 24) auf einer ersten Oberfläche davon;
einen Werkstoff zur Wärmeabgabe (23), mit einer zweiten Oberfläche des genannten dielektrischen Werkstoffs verbunden, und
wobei die genannten metallisierten Flächen des erstgenannten Streifens elektrisch, mechanisch und themisch mit den genannten metallisierten Flächen des zweitgenannten filmförmigen dielektrischen Werkstoffs über die genannten Löcher, die unter jeder metallisierten Fläche des erstgenannten Streifens liegen, untereinander verbunden sind.

12. Starkstrom-Halbleitervorrichtungspackung nach Anspruch 11, bei der Polyimid zum zweitgenannten filmförmigen dielektrischen Werkstoff gehört.

13. Starkstrom-Halbleitervorrichtungspackung nach Anspruch 8, bei der Alumium zum Wärmeabgabematerial gehört.

## Revendications

1. Empaquetage de dispositif semiconducteur de puissance, caractérisé en ce qu'il comprend:
une bande en matériau diélectrique (1) dont l'une des surfaces comporte au moins deux régions métallisées distinctes (6, 7, 8),
un élément électriquement et thermiquement conducteur (9) servant à égaliser les dilatations thermiques, monté sur une première (8) desdites régions métallisées,
un dispositif semiconducteur de puissance (10) monté sur la surface dudit élément égaliseur (9) opposée à celle qui est montée sur la région métallisée (8),
des conducteurs en forme de poutre (11, 12) établissement une connexion électrique entre des parties dudit dispositif semiconducteur et l'autre région métallisée,
ledit élément égaliseur (9) égalisant les taux de dilatation thermique respectives du matériau semiconducteur du dispositif de puissance et du matériau constituant le puits de chaleur de l'empaquetage.

2. Empaquetage de dispositif semiconducteur de puissance selon la revendication 1, comprenant en outre un trou (3, 4, 5) pratiqué dans ladite bande composée de matériau diélectrique audessous de chacune desdites régions métallisées.

3. Empaquetage de dispositif semiconducteur de puissance selon la revendication 1 ou 2, dans lequel lesdites régions métallisées comportent une couche de cuivre relativement mince.

4. Empaquetage de dispositif semiconducteur de puissance selon l'une quelconque des revendications 1 à 3, dans lequel ledit film se compose d'un polyimide.

5. Empaquetage de dispositif semiconducteur de puissance selon l'une quelconque des revendications 1 à 4, dans lequel les surfaces exposées desites régions métallisées sont au moins partiellement recouvertes d'une couche d'or très fine.

6. Empaquetage de dispositif semiconducteur de puissance selon l'une quelconque des revendications 1 à 5, dans lequel ledit élément égaliseur des dilatations termiques se compose d'un sandwich de cuivre-molybdène-cuivre.

7. Empaquetage de dispositif semiconducteur de puissance selon l'une quelconque des revendications 1 à 5, dans lequel ledit élément égaliseur des dilatations thermiques comprend un noyau en alliage d'acier contenant 36% environ de nickel, ledit noyau étant revêtu de cuivre.

8. Empaquetage de dispositif semiconducteur de puissance selon l'une quelconque des revendications 1 à 7, comprenant en outre un matériau plastique de passivation (13) présentant un faible coefficient de dilatation et recouvrant au moins ledit dispositif semiconducteur de puissance.

9. Empaquetage de dispositif semiconducteur de puissance selon la revendication 8, dans lequel ledit matériau plastique de passivation se compose de matériaux polymériques d'enrobage.

10. Empaquetage de dispositif semiconducteur de puissance selon la revendication 9, dans lequel ledit matériau polymérique d'enrobage se compose d'une résine époxyde d'une grande pureté comportant un matériau de remplissage en silice.

11. Empaquetage de dispositif semiconducteur de puissance, caractérisé en ce qu'il comprend:

une première bande (1) de matériau diélectrique dont une première surface est pourvue d'au moins deux régions métallisées distinctes (6, 7, 8), ledit matériau diélectrique comportant un trou (3, 4, 5) pratiqué sous chacune desdites régions métallisées,

une élément (9) d'égalisation des dilatations thermiques monté sur une première (8) desdites régions métallisées,

un conducteur en forme de poutre (12) connectant une partie dudit dispositif semiconducteur à une seconde (7) desdites régions métallisées, une seconde bande (21) en matériau diélectrique dont une première surface est pourvue d'au moins deux régions métallisées (20, 24),

un matériau (23) constituant un puits de chaleur et fixé à une seconde surface dudit second matériau diélectrique, et

lesdites régions métallisées de ladite première band étant connectées électriquement, mécaniquement et thermiquement auxdites régions métallisées de ladite seconde bande de matériau diélectrique traversant ledit trou pratiqué sous chacune desdites régions métallisées de ladite première bande.

12. Empaquetage de dispositif semiconducteur de puissance selon la revendication 11, dans lequel ladite seconde bande de matériau diélectrique se compose d'un polyimide.

13. Empaquetage de dispositif semiconducteur de puissance selon la revendication 12, dans lequel ledit puits de chaleur se compose d'aluminium.

FIG. 1

FIG. 2

FIG. 3

FIG. 4